# FASCICULE DE BREVET EUROPEEN

(11) **EP 4 205 173 B1**
(45) Date de publication et mention de la délivrance du brevet: **31.07.2024**
(21) Numéro de dépôt: 21765949.9
(22) Date de dépôt: 26.08.2021
(51) Int. Cl.: H01L 23/528, H01L 23/482, H01L 23/522

(54) **COMPOSANT A HAUTE MOBILITE ELECTRONIQUE**
BAUELEMENT MIT HOHER ELEKTRONENBEWEGLICHKEIT
COMPONENT WITH HIGH ELECTRON MOBILITY

(30) Priorité: 28.08.2020 FR 2008793
(43) Date de publication de la demande: 05.07.2023
(73) Titulaire: Commissariat à l'Energie Atomique et aux Energies Alternatives, 75015 Paris (FR)
(72) Inventeur: BERGOGNE, Dominique, 38054 GRENOBLE CEDEX 09 (FR); ROTHAN, Frédéric, 38054 GRENOBLE CEDEX 09 (FR)
(74) Mandataire: Cabinet Beaumont
(86) Numéro de dépôt international: PCT/EP2021/073652
(87) Numéro de publication internationale: WO 2022/043459

(56) Documents cités:
- WO-A1-2015/157845
- US-A- 5 672 894
- US-A1- 2020 152 572

## Description

La présente demande de brevet revendique la priorité de la demande de brevet français FR20/08793 qui sera considérée comme faisant partie intégrante de la présente description.

### Domaine technique

La présente description concerne de façon générale les dispositifs électroniques, et, en particulier, des composants dits à haute mobilité électronique, plus particulièrement des composants à haute mobilité électronique de type dit "planar".

### Technique antérieure

Des composants, tels que des transistors et des diodes, sont de type dit à haute mobilité électronique. Ces composants comprennent deux couches semiconductrices ayant des bandes interdites différentes et situées l'une sur l'autre. Les semiconducteurs des deux couches, en particulier leurs bandes interdites, sont choisies de telle sorte que les électrons sont mobiles le long d'une interface entre les deux couches. Les électrons ainsi rendus mobiles définissent un gaz d'électrons bidimensionnel.

Un composant à haute mobilité électronique est typiquement compris dans une puce électronique de circuit intégré, définie par un substrat tel qu'une portion de plaquette (en anglais "wafer"), de préférence semiconductrice, sur une face de laquelle le composant est situé. Le composant peut être de type dit "planar", c'est-à-dire qu'il comprend des plages ou plots de connexion (en anglais "connection pad") toutes disposées sur la face de la puce sur laquelle le composant est situé.

Le composant à haute mobilité électronique comprend typiquement une ou plusieurs zones actives semiconductrices comprenant chacune un gaz d'électrons bidimensionnel. Le composant comprend en outre des couches d'isolant électrique recouvrant la ou les zones actives, et, dans ces couches d'isolant électrique, un réseau de conducteurs qui connecte électriquement les plages de connexion aux zones actives semiconductrices. La résistance électrique présentée par le réseau de conducteurs entre les plages de connexion et les zones actives est en série dans le composant et contribue à la résistance à l'état passant du composant.

US2020152572 décrit un composant électronique comprenant des pistes de source et de drain interdigitées.

WO2015157845 décrit des transistors de puissance au GaN latéraux.

US5672894 décrit un dispositif semiconducteur comprenant des pistes de source et de drain ayant un motif en forme de peigne.

### Résumé de l'invention

Il existe un besoin d'améliorer les composants connus à haute mobilité électronique, en particulier de diminuer la résistance du réseau de conducteurs et/ou sa surface occupée, afin de diminuer l'encombrement et/ou la résistance à l'état passant de ces composants.

Un mode de réalisation pallie tout ou partie des inconvénients des composants connus à haute mobilité électronique.

Un mode de réalisation prévoit d'améliorer un compromis entre une surface occupée par un composant à haute mobilité électronique et une résistance du composant à l'état passant.

Ainsi, un mode de réalisation prévoit un composant de type à haute mobilité électronique, dans lequel :
- des pistes de connexion d'électrodes sont parallèles entre elles ;
- sur les pistes, au moins une paire de régions collectrices de courant s'étendent de part et d'autre d'une séparation entre les régions, à partir de ladite séparation, jusqu'à deux bords opposés des régions ; et
- la séparation est oblique par rapport aux pistes et les deux bords opposés sont orthogonaux aux pistes.

Selon un mode de réalisation, chacune desdites pistes passe sous au moins l'une des deux régions.

Selon un mode de réalisation, lesdites pistes comprennent des premières pistes de connexion de première électrode et des deuxièmes pistes de connexion de deuxième électrode disposées de manière alternée.

Selon un mode de réalisation, l'une des régions de la paire est connectée par des vias aux premières pistes et une autre des régions de la paire est connectée par des vias aux deuxièmes pistes.

Selon un mode de réalisation, lesdites régions sont des portions d'une même couche métallique.

Selon un mode de réalisation, ladite paire est répétée régulièrement dans une direction parallèle aux pistes.

Selon un mode de réalisation :
- des premières régions des paires s'étendent à partir d'une même première bande de la couche métallique, la première bande s'étendant parallèlement aux pistes ; et
- de préférence, des deuxièmes régions des paires s'étendent à partir d'une même deuxième bande de la couche métallique, la deuxième bande s'étendant parallèlement aux pistes.

Selon un mode de réalisation, un espace entre paires voisines a une largeur sensiblement égale à une largeur de la séparation.

Selon un mode de réalisation, lesdites régions présentent chacune une plage de connexion.

Selon un mode de réalisation, les plages sont entièrement situées au-dessus desdites pistes et d'espaces entre lesdites pistes.

Selon un mode de réalisation, les plages de connexion des régions connectées aux premières pistes sont connectées à une première borne du composant, et les plages de connexion des régions connectées aux deuxièmes pistes sont connectées à une deuxième borne du composant.

Un mode de réalisation prévoit un composant à AlGaN/GaN tel que défini ci-dessus.

Un mode de réalisation prévoit un transistor comprenant un ou plusieurs composants tels que définis ci-dessus.

Selon un mode de réalisation, le transistor comprend des électrodes de drain, de grille et de source formant des bandes allongées parallèlement aux pistes, les électrodes de drain étant connectées par des vias à des pistes de drain parmi lesdites pistes, et les électrodes de source étant connectées par des vias à des pistes de source parmi lesdites pistes.

Selon un mode de réalisation, les électrodes de grille sont situées sous les pistes de source.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière partielle et schématique, une vue de dessus d'un exemple d'un mode de réalisation d'un transistor à haute mobilité électronique ;
la figure 2 représente, de manière partielle et schématique, une vue en coupe du transistor de la figure 1 ; et
la figure 3 représente, de manière partielle et schématique, un exemple d'un autre mode de réalisation d'un transistor à haute mobilité électronique.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des procédés mis en oeuvre pour obtenir des éléments d'un composant à haute mobilité électronique tels qu'une zone active, des électrodes, des pistes conductrices et des régions conductrices dans des niveaux de métal, des vias, des isolants électriques, des plages et des plots de contact, etc., ainsi que des matériaux et dimensions de ces éléments, ne sont pas décrits en détail, les modes de réalisation décrits étant compatibles avec les procédés de fabrication usuels de ces éléments et avec les matériaux et dimensions usuelles de ces éléments.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

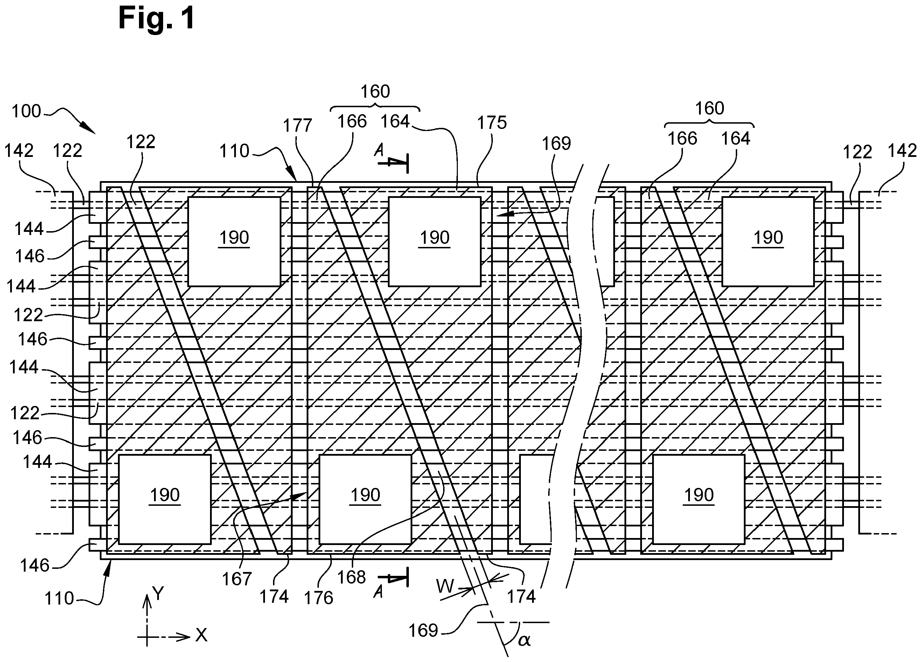

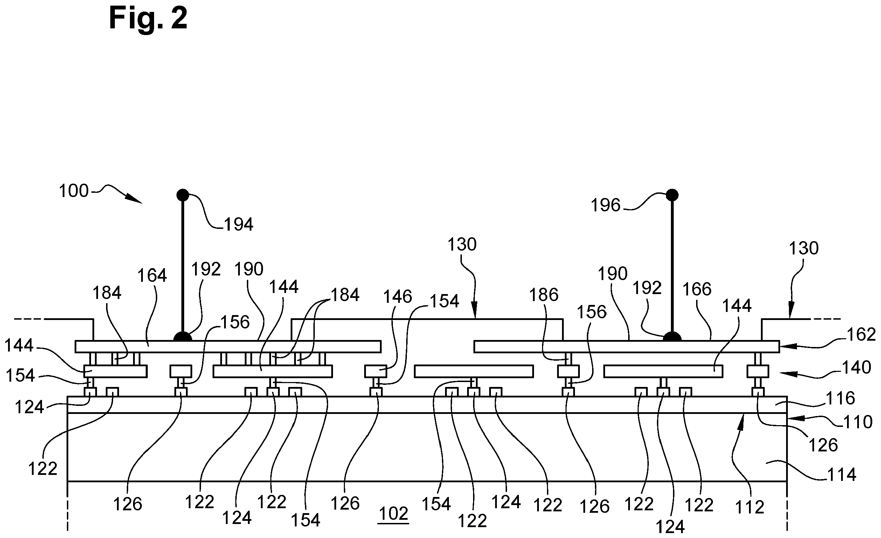

Les figures 1 et 2 représentent, de manière partielle et schématique, des vues respectives de dessus et en coupe selon un plan A-A d'un exemple d'un mode de réalisation d'un transistor 100 à haute mobilité électronique. La figure 2 est à une échelle grossie par rapport à la figure 1.

De préférence, le transistor 100 comprend, outre une partie représentée de manière interrompue, d'autres parties non représentées identiques, à des variations près dues au procédé de fabrication, ou similaires, à la partie représentée. A titre d'exemple, ces parties sont disposées en ligne ou en matrice.

Le transistor 100 comprend un support 102 (représenté seulement en figure 2), de préférence constitué par une portion de plaquette, plus préférentiellement en silicium. Sur le support 102, le transistor 100 comprend une zone active 110 à haute mobilité électronique. Par zone active à haute mobilité électronique, on entend un empilement de couches semiconductrices 114 et 116 formant un gaz d'électrons bidimensionnel 112 le long d'une interface entre ces couches. Autrement dit, le transistor 100 est de type transistor à haute mobilité électronique, HEMT (de l'anglais "High Electron-Mobility Transistor"). De préférence, les couches 114 et 116 sont respectivement en nitrure de gallium GaN et en nitrure d'aluminium-gallium AlGaN recouvrant la couche 114 de GaN. Autrement dit, le transistor 100 est de type HEMT à AlGaN/GaN.

Le transistor 100 comprend des électrodes de grille 122, de source 124 (représentée seulement en figure 2), et de drain 126 (représentée seulement en figure 2) situées sur la zone active 110. Ces électrodes 122, 124 et 126 forment, en vue de dessus, des bandes allongées dans une direction X (horizontale en figure 1, et orthogonale au plan de la figure 2). Autrement dit, chacune des électrodes de grille 122, de source 124, et de drain 126 forme une barre rectiligne ayant pour direction principale la direction X.

De préférence, les électrodes de drain 126 et de source 124 sont disposées de manière alternée dans une direction Y orthogonale à la direction X, et les électrodes de grille 122 sont intercalées entre les électrodes de drain 126 et de source 124.

Le transistor 100 comprend un niveau de métal 140. Par niveau de métal, on entend une couche métallique située entre des couches d'isolant 130. Plus précisément, cette couche métallique est incomplète, des portions de cette couche formant des régions métalliques isolées électriquement les unes des autres de sorte que ces régions forment des connexions électriques telles que des pistes.

Le niveau de métal 140 comprend des pistes de source 144 et des pistes de drain 146. Les pistes de source 144 et de drain 146 ont, en vue de dessus, des formes de bandes rectilignes ayant la direction X pour direction principale. Les pistes de drain 146 et de source 144 sont donc parallèles entre elles.

De préférence, les électrodes de drain 126 sont entièrement situées sous les pistes de drain 146, et les électrodes de source 124 sont entièrement situées sous les pistes de source 144. Les électrodes de drain 126 sont alors connectées par des vias 156 aux pistes de drain 146, et les électrodes de source 124 sont connectées par des vias 154 aux pistes de source 144.

De préférence, les pistes de source 144 et de drain 146 ont une même longueur (c'est-à-dire une même dimension dans la direction X) et ont leurs extrémités alignées selon la direction Y.

De préférence, chaque piste de source 144 s'étend dans la direction Y à partir de l'aplomb (c'est-à-dire la verticale dans l'orientation de la vue en coupe) de l'électrode de source 124 concernée, et recouvre une électrode de grille 122 ou les deux électrodes de grilles 122 situées de part et d'autre de l'électrode de source 124. Les électrodes de grille 122 sont donc situées sous les pistes de source 144. Les pistes de source 144 constituent ainsi des écrans électrostatiques pour les électrodes de grille 122.

De préférence, les électrodes de grille 122 dépassent des extrémités des pistes de source 144. Autrement dit, les électrodes de grille 122 ont une longueur supérieure à celle des pistes de source 144 et ont, au-delà des extrémités des pistes de source 144, des parties non recouvertes par les pistes de source 144.

De préférence, deux régions métalliques 142 sont disposées de part et d'autre des pistes de drain 146 et de source 144 dans la direction X sur les parties des électrodes de grille 122 non recouvertes par les pistes de source 144. Les électrodes de grille 122 sont alors connectées aux régions métalliques 142 par des vias non représentés. Plus préférentiellement, les régions métalliques 142 sont des régions du niveau de métal 140. Les régions métalliques 142 sont de préférence rectangulaires allongées dans la direction Y.

De préférence, l'une et/ou l'autre des régions métalliques 142 est commune à la partie représentée de manière interrompue et à une autre partie identique du transistor 100 (à des variations près dues à la fabrication), par exemple située dans une même ligne ou une même rangée de matrice, la ligne ou la rangée étant une répétition dans la direction X de parties identiques à celle représentée. A titre d'exemple, le transistor est constitué de deux parties identiques à la partie représentée. En variante, le transistor comprend un seul exemplaire de la partie représentée.

Le transistor 100 comprend, sur les pistes de drain 146 et de source 144, des paires 160 de régions conductrices 164 et 166 (hachurées en figure 1). Dans chaque paire 160, les régions 164 et 166 sont disjointes, c'est-à-dire qu'un espace 168, ou séparation, isole les régions 164 et 166 l'une de l'autre. La séparation 168 a, en vue de dessus, la forme d'une bande entre les régions 164 et 166.

La région 164 s'étend, selon la direction X, à partir de la séparation 168 jusqu'à un bord 165 de la région 164. La région 166 s'étend, selon la direction X, à partir de la séparation 168 jusqu'à un bord 167 de la région 166. Autrement dit, les régions 164 et 166 s'étendent selon la direction X dans deux sens opposés à partir de la séparation 168 jusqu'aux bords respectifs 165 et 167. Les bords 165 et 167 constituent ainsi deux bords opposés de la paire 160.

La séparation 168 est oblique par rapport aux pistes de source 144 et de drain 146, c'est-à-dire que la direction d'allongement de la séparation 168 forme avec la direction X des angles différents de l'angle droit, c'est-à-dire un angle aigus et un angle supplémentaire obtus. De préférence, la bande rectiligne définie par la séparation 168 a un axe médian 169 définissant une direction principale ou longitudinale de la séparation 168, et une largeur (dimension transversale) constante. L'axe 169 et la direction X ont entre eux un angle α de préférence supérieur à 45 degrés, par exemple compris entre 50 degrés ou environ 50 degrés, et 85 degrés, ou environ 85 degrés.

Les bords de la séparation 168 peuvent être rectilignes. Cependant, les bords de la séparation 168 peuvent également présenter des ondulations. De préférence, la séparation 168 a alors, dans une direction orthogonale à l'axe 169, une largeur W sensiblement constante. De telles ondulations peuvent permettre de faciliter l'obtention, pour les bords de la séparation 168, d'une forme sensiblement rectiligne à l'échelle de la largeur W, en formant les bords de la séparation 168 à partir d'une succession de segments ayant, avec la direction X, des angles prédéfinis, par exemple de 90 et 45 degrés. Des angles prédéfinis sont typiques dans les outils usuels de conception de composants électroniques. Par forme sensiblement rectiligne, on entend que, pour chaque bord de la forme, la distance entre ce bord et une droite moyenne est inférieure à 20 %, de préférence 10 %, plus préférentiellement 5 % de la largeur W de la forme.

La largeur W peut être comprise entre 1 µm et 20 µm. Dans un exemple, la largeur W est de l'ordre de 10 µm, et les ondulations peuvent alors être de l'ordre de 1 µm. Plus précisément, la largeur W est choisie suffisamment élevée pour isoler électriquement les régions 164 et 166 lorsque le transistor est à l'état bloqué et qu'il bloque une tension. A titre d'exemple, la tension bloquée par le transistor peut être supérieure à 500 V, par exemple de l'ordre de 650 V.

De préférence, les régions 164 et 166 sont des régions d'un même niveau de métal 162 situé au-dessus du niveau de métal 140, autrement dit, les régions 164 et 166 sont des portions d'une même couche métallique.

De préférence, chacune des pistes de drain 146 et de source 144 passe sous les deux régions 164 et 166.

De préférence, chacune des pistes de source 144 est reliée à la région 164 par un ou, de préférence, plusieurs vias 184 situés sur la partie de la piste de source 144 située sous la région 164. Ainsi, la région électriquement conductrice 164 permet la collecte d'un courant passant par la source lorsque le transistor 100 est à l'état passant. Autrement dit, la région 164 constitue une région collectrice de courant du transistor 100. Les pistes 144 constituent des pistes de connexion des électrodes de source 124 à la région 164.

De préférence, chacune des pistes de drain 146 est reliée à la région 166 par un ou, de préférence, plusieurs vias 186 situés sur la partie de la piste de drain 146 située sous la région 166. Ainsi, la région électriquement conductrice 166 permet la collecte d'un courant passant par le drain lorsque le transistor 100 est passant. Autrement dit, la région 166 constitue une autre région collectrice de courant du transistor 100. Les pistes 146 constituent des pistes de connexion des électrodes de drain 126 à la région 166.

Plus préférentiellement, on prévoit qu'entre chaque piste 144, 146 et la région respective 164, 166, le nombre de vias respectif 184, 186 soit proche du plus grand nombre possible permis par le manuel de règles de conceptions DRM (en anglais "Design Rules Manual") pour la technologie mise en oeuvre.

Les deux bords opposés 165 et 167 sont rectilignes et orthogonaux à la direction X. Autrement dit, les deux bords opposés 165 et 167 sont orthogonaux aux pistes de source 144 et de drain 146. Ainsi, du fait que la séparation 168 est oblique, chaque région 164, 166 présente, entre la séparation 168 et le bord respectif 165, 167, une forme de trapèze rectangle dans le cas où la séparation 168 ne rejoint pas le bord respectif 165, 167, ou une forme de triangle rectangle dans le cas où la séparation 168 rejoint le bord respectif 165, 167. Les régions 164 et 166 ont une dimension dans la direction X, c'est-à-dire la largeur de ces régions, qui diminue dans la direction Y dans un sens pour la région 166 et dans l'autre sens pour la région 164.

Selon un mode de réalisation, la région 164 a deux bords opposés 174 et 175 parallèles à la direction X, et la région 166 a deux bords opposés 176 et 177 parallèles à la direction X. De préférence, les bords 177 et 175 sont colinéaires dans la direction X, et les bords 174 et 176 sont colinéaires dans la direction X. Ainsi, les régions 164 et 166 ont, en vue de dessus, la forme d'un rectangle interrompu par la séparation 168. De préférence, l'axe 169 passe par le centre du rectangle. Les régions 164 et 166 sont alors, en vue de dessus, symétriques par rapport au centre du rectangle, ou symétrique par rapport à ce centre aux ondulations décrites ci-dessus près. Par symétrique, on entend symétrique à des variations près dues aux tolérances du procédé de fabrication.

De préférence, les paires 160 sont répétées régulièrement dans la direction X. De préférence, le nombre de paires 160 situées dans la partie représentée de manière interrompue, c'est-à-dire entre deux régions métalliques 142, est compris entre trois et dix, par exemple égal à trois, cinq, six ou dix paires. Le nombre de paires est choisi en fonction de la tenue en tension souhaitée (tension maximale que le transistor à l'état bloqué est capable de bloquer) et de la résistance à l'état passant souhaitée. En variante, on peut prévoir une seule paire 160, deux paires 160 ou plus de dix paires 160. De préférence, les paires 160 sont identiques, à des variations près dues au procédé de fabrication. De préférence, les paires 160 voisines sont séparées par un espace ayant dans la direction X, entre le bord 165 de l'une des paires 160 et le bord 167 de la paire 160 voisine, une largeur sensiblement égale à la largeur W des séparations 168.

On aurait pu prévoir que les bords opposés 165 et 167 de la paire 160 soient obliques, par exemple que les bords 165 et 167 des paires 160 voisines fassent avec la direction X un angle π-α supplémentaire de l'angle α. En comparaison, dans les modes de réalisation, le fait de prévoir que les bords opposés 165 et 167 soient orthogonaux aux pistes 144 et 146, permet que les régions 164 et 166 les plus proches des extrémités des pistes 144 et 146 présentent avec les autres régions 164 et 166 une même largeur diminuant dans la direction Y, et permet que les régions 164 et 166 recouvrent les pistes 144 et 146 près de leurs extrémités sans que certaines des pistes 144 et 146 soient moins recouvertes que d'autres et sans qu'une partie des régions 164 et 166 s'étende au-delà des extrémités des pistes 144 et 146. Ceci permet de diminuer la résistance électrique de la collecte du courant des extrémités des pistes 144 et 146 qui, sinon, ne seraient pas recouvertes, et/ou permet d'éviter de perdre une partie de surface du transistor pour laisser de la place à une région qui s'étendrait au-delà des extrémités des pistes 144 et 146. Le compromis entre résistance à l'état passant du transistor 100 et la surface du transistor est donc amélioré.

Selon un mode de réalisation, chaque région 164, 166 présente une plage de connexion 190. Les plages de connexion 190 peuvent comprendre chacune une ouverture dans les couches d'isolant 130. L'ouverture débouche sur le métal de la région 164, 166 concernée. Les plages de connexions 190 peuvent comprendre, dans ces ouvertures, des contacts 192 avec les plages de connexions. Les contacts 192 des régions 164 sont connectés à une borne de source 194 du transistor 100, et les contacts 192 des régions 166 sont connectés à une borne de drain 196 du transistor 100.

De préférence, les plages de connexion 190 ont une forme prédéfinie, par exemple carrée, de dimensions également prédéfinies. Une telle forme prédéfinie, avec des dimensions prédéfinies, est typique dans les outils usuels de conception de plages de connexion ou de plots de connexion. On prévoit alors, plus préférentiellement, que la largeur selon la direction X des régions 164 et 166 permettent que les plages 190 soient entièrement situées au-dessus des pistes 144 et 146 et des espaces entre ces pistes.

En particulier, le fait de prévoir que les bords 165 et 167 soient orthogonaux aux pistes 144 et 146, permet d'éviter, pour les régions 164 et 166 les plus proches des extrémités des pistes 144 et 146, qu'une partie de plage de connexion 190 soit située au-delà des extrémités des pistes 144 et 146. Prévoir une telle partie de plage de connexion nécessiterait une surface supplémentaire. Il en résulte que la prévision des bords 165 et 167, et la prévision des plages 190 entièrement situées au-dessus des pistes 144 et 146 et des espaces entre ces pistes, permet de réduire la surface occupée par le transistor 100.

En variante, les régions 164 et 166 peuvent se prolonger dans le niveau de métal 162 par d'autres régions du niveau de métal 162, et les plages de connexion 190 peuvent être en partie situées sur ces autres régions. Par rapport à cette variante, un avantage de prévoir que les plages 190 soient entièrement situées au-dessus des pistes 144 et 146 et d'espaces entre ces pistes est également de réduire la surface de transistor 100.

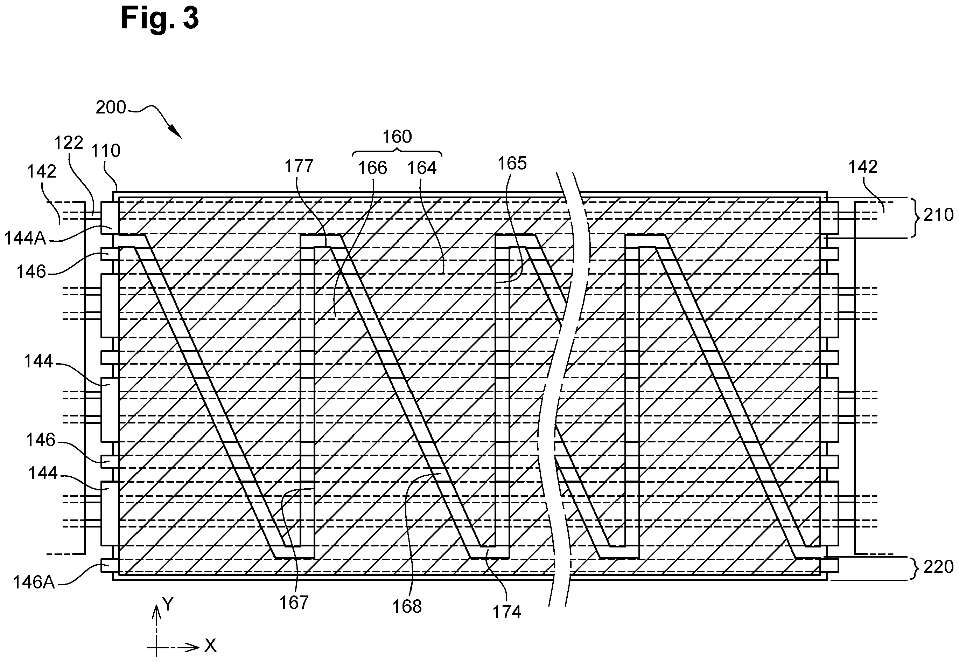

La figure 3 représente, de manière partielle et schématique, un exemple d'un autre mode de réalisation d'un transistor 200 à haute mobilité électronique.

Le transistor 200 comprend des éléments identiques ou similaires à ceux du transistor 100 des figures 1 et 2, agencés de manière identique ou similaire. Ces éléments ne sont pas décrits à nouveau en détails. Seules les différences sont mises en exergue.

Le transistor 200 diffère du transistor 100 des figures 1 et 2 en ce qu'il comprend des bandes 210 du niveau de métal des régions 164 (de préférence, le niveau 162) et/ou des bandes 220 du niveau de métal des régions 166 (de préférence, également le niveau 162). De préférence, la ou les bandes 210 et 220 remplacent les plages de connexion 190, qui sont alors omises. En variante, les plages de connexion ne sont pas omises. Les bandes 210 et 220 s'étendent dans la direction X parallèlement aux pistes 144 et 146.

Les régions 164 s'étendent sur les pistes 144 et 146 selon la direction Y à partir de la bande 210, et, de préférence, les régions 166 s'étendent sur les pistes 144 et 146 selon la direction Y à partir de la bande 220.

Autrement dit, les bandes 210 et 220, et les régions 164 et 166 ont la forme de peignes interdigités, les dents ou doigts des peignes ayant des formes de trapèzes rectangle ou de triangles rectangles. La bande 210 connecte électriquement les régions 164 entre elles, et la bande 220 connecte électriquement les régions 166 entre elles. De préférence, la bande 210 est connectée (par des connexions non représentées) à une borne de source du transistor 200, et la bande 220 est connectée à une borne de drain du transistor 200.

Dans l'exemple représenté, l'une des pistes de source 144 (144A) est située, au moins sur une partie de la largeur de cette piste dans la direction Y, sous la bande 210. La piste de source 144A est alors connectée à la bande 210 par des vias non représentés. Dans ce cas, chacune des pistes de drain 146, à l'exception de la piste 146A, peut passer sous toutes les régions 164 connectées aux pistes de source 144.

Dans l'exemple représenté, l'une des pistes de drain 146 (146A) est située, au moins sur une partie de la largeur de cette piste, sous la bande 220. La piste de drain 146A est alors connectée à la bande 220 par des vias non représentés. Dans ce cas, préférentiellement, chacune des pistes de source 144, à l'exception de la piste 144A, passe sous toutes les régions 166 connectées aux pistes de drain 146.

L'exemple représenté n'est pas limitatif, la bande 210 et/ou la bande 220 pouvant également être situées en dehors de l'aplomb de l'ensemble formé par les pistes 144 et 146 et des espaces entre ces pistes.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'on ait décrit ci-dessus des modes de réalisation d'un transistor, d'autres modes de réalisation prévoient une diode à haute mobilité électronique. La personne du métier est en mesure d'obtenir une diode à partir des éléments décrits ci-dessus pour un transistor, en particulier de remplacer les électrodes de drain et de source décrites ci-dessus par des électrodes d'anode et de cathode de la diode.

Enfin, la mise en oeuvre pratique des modes de réalisation et variantes décrits est à la portée de la personne du métier à partir des indications fonctionnelles données ci-dessus.

## Revendications

1. Composant (100, 200) de type à haute mobilité électronique, dans lequel :
- des pistes (144, 146) de connexion d'électrodes sont parallèles entre elles ;
- sur les pistes, au moins une paire (160) de régions (164, 166) collectrices de courant s'étendent, dans la direction (X) des pistes (144, 146), de part et d'autre d'une séparation (168) entre les régions, à partir de ladite séparation (168), jusqu'à deux bords opposés (165, 167) des régions ; et
- la séparation est oblique par rapport aux pistes et les deux bords opposés sont orthogonaux aux pistes.

2. Composant selon la revendication 1, dans lequel les régions (14, 166) collectrices de courant ont la forme de triangles rectangles.

3. Composant selon la revendication 1, dans lequel les régions (14, 166) collectrices de courant ont la forme de trapèzes rectangles.

4. Composant selon l'une quelconque des revendications 1 à 3, dans lequel chacune desdites pistes (144, 146) passe sous au moins l'une des deux régions (164, 166).

5. Composant selon l'une quelconque des revendications 1 à 4, dans lequel lesdites pistes (144, 146) comprennent des premières pistes (144) de connexion de première électrode et des deuxièmes pistes de connexion (146) de deuxième électrode disposées de manière alternée.

6. Composant selon la revendication 5, dans lequel l'une des régions (164) de la paire (160) est connectée par des vias (184) aux premières pistes (144) et une autre des régions (166) de la paire est connectée par des vias (186) aux deuxièmes pistes (146).

7. Composant selon l'une quelconque des revendications 1 à 6, dans lequel lesdites régions (164, 166) sont des portions d'une même couche métallique (162).

8. Composant selon l'une quelconque des revendications 1 à 7, dans lequel ladite paire (160) est répétée régulièrement dans une direction (X) parallèle aux pistes (144, 146).

9. Composant selon les revendications 7 et 8, dans lequel :
- des premières régions (164) des paires (160) s'étendent à partir d'une même première bande (210) de la couche métallique (162), la première bande s'étendant parallèlement aux pistes (144, 146) ; et
- de préférence, des deuxièmes régions (166) des paires s'étendent à partir d'une même deuxième bande (220) de la couche métallique, la deuxième bande s'étendant parallèlement aux pistes.

10. Composant selon la revendication 8 ou 9, dans lequel un espace entre paires (160) voisines a une largeur sensiblement égale à une largeur (W) de la séparation (168).

11. Composant selon l'une quelconque des revendications 1 à 10, dans lequel lesdites régions (164, 166) présentent chacune une plage de connexion (190).

12. Composant selon la revendication 11, dans lequel les plages (190) sont entièrement situées au-dessus desdites pistes (144, 146) et d'espaces entre lesdites pistes.

13. Composant selon la revendication 11 ou 12 dans sa dépendance à la revendication 3, dans lequel les plages de connexion (190) des régions (164) connectées aux premières pistes (144) sont connectées à une première borne (194) du composant, et les plages de connexion des régions (166) connectées aux deuxièmes pistes (146) sont connectées à une deuxième borne (196) du composant.

14. Composant à AlGaN/GaN selon l'une quelconque des revendications 1 à 13.

15. Transistor (100, 200) comprenant un ou plusieurs composants selon l'une quelconque des revendications 1 à 14.

16. Transistor selon la revendication 15, comprenant des électrodes de drain (126), de grille (122) et de source (124) formant des bandes allongées parallèlement aux pistes, les électrodes de drain étant connectées par des vias (156) à des pistes de drain (146) parmi lesdites pistes, et les électrodes de source étant connectées par des vias (154) à des pistes de source (144) parmi lesdites pistes.

17. Transistor selon la revendication 16, dans lequel les électrodes de grille (122) sont situées sous les pistes de source (144).

## Patentansprüche

1. Bauelement (100, 200) des Typs mit hoher Elektronenbeweglichkeit, wobei:
- Elektrodenverbindungsbahnen (144, 146) parallel zueinander verlaufen;
- sich auf den Bahnen mindestens ein Paar (160) von Stromkollektorbereichen (164, 166) in der Richtung (X) der Bahnen (144, 146) beiderseits einer Trennung (168) zwischen den Bereichen bis zu zwei entgegengesetzten Kanten (165, 167) der Bereiche erstreckt; und
- die Trennung schräg zu den Bahnen verläuft und die beiden entgegengesetzten Kanten orthogonal zu den Bahnen sind.

2. Bauelement nach Anspruch 1, wobei die Stromkollektorbereiche (14, 166) die Form von rechtwinkligen Dreiecken haben.

3. Bauelement nach Anspruch 1, wobei die Stromkollektorbereiche (14, 166) die Form von rechtwinkligen Trapezen haben.

4. Bauelement nach einem der Ansprüche 1 bis 3, wobei jede der Bahnen (144, 146) unter mindestens einem der beiden Bereiche (164, 166) verläuft.

5. Bauelement nach einem der Ansprüche 1 bis 4, wobei die Bahnen (144, 146) erste Verbindungsbahnen (144) von ersten Elektroden und zweite Verbindungsbahnen (146) von zweiten Elektroden aufweisen, die abwechselnd angeordnet sind.

6. Bauelement nach Anspruch 5, wobei einer der Bereiche (164) in dem Paar (160) über Durchkontaktierungen (184) mit den ersten Bahnen (144) und ein anderer der Bereiche (166) in dem Paar über Durchkontaktierungen (186) mit den zweiten Bahnen (146) verbunden ist.

7. Bauelement nach einem der Ansprüche 1 bis 6, wobei die Bereiche (164, 166) Teile einer gleichen Metallschicht (162) sind.

8. Bauelement nach einem der Ansprüche 1 bis 7, wobei sich das Paar (160) regelmäßig in einer Richtung (X) parallel zu den Leiterbahnen (144, 146) wiederholt.

9. Bauelement nach den Ansprüchen 7 und 8, wobei:
- erste Bereiche (164) der Paare (160) sich von einem gleichen ersten Streifen (210) der Metallschicht (162) erstrecken, wobei sich der erste Streifen parallel zu den Leiterbahnen (144, 146) erstreckt; und
- erste Bereiche (166) der Paare sich vorzugsweise von einem gleichen zweiten Streifen (220) der Metallschicht erstrecken, wobei sich der zweite Streifen parallel zu den Bahnen erstreckt.

10. Bauelement nach Anspruch 8 oder 9, wobei ein Zwischenraum zwischen benachbarten Paaren (160) eine Breite aufweist, die im Wesentlichen gleich einer Breite (W) der Trennung (168) ist.

11. Bauelement nach einem der Ansprüche 1 bis 10, wobei die Bereiche (164, 166) jeweils einen Verbindungsbereich (190) aufweisen.

12. Bauelement nach Anspruch 11, wobei die Bereiche (190) vollständig oberhalb der Bahnen (144, 146) und der Zwischenräume zwischen den Bahnen angeordnet sind.

13. Bauelement nach Anspruch 11 oder 12 in Abhängigkeit von Anspruch 3, wobei die Verbindungsbereiche (190) der mit den ersten Bahnen (144) verbundenen Bereiche (164) mit einem ersten Anschluss (194) des Bautelements verbunden sind und die Verbindungsbereiche der mit den zweiten Bahnen (146) verbundenen Bereiche (166) mit einem zweiten Anschluss (196) des Bauelements verbunden sind.

14. AIGaN/GaN-Bauelement nach einem der Ansprüche 1 bis 13.

15. Transistor (100, 200) mit einem oder mehreren Bauelementen nach einem der Ansprüche 1 bis 14.

16. Transistor nach Anspruch 15, aufweisend Drain- (126), Gate- (122) und Source-Elektroden (124), die Streifen bilden, die sich parallel zu den Bahnen erstrecken, wobei die Drain-Elektroden über Durchkontaktierungen (156) mit Drain-Bahnen (146) der Bahnen verbunden sind und die Source-Elektroden über Durchkontaktierungen (154) mit Source-Bahnen (144) der Bahnen verbunden sind.

17. Transistor nach Anspruch 16, wobei die Gate-Elektroden (122) unter den Source-Bahnen (144) angeordnet sind.

## Claims

1. Component (100, 200) of high electron mobility type, wherein:
- electrode connection tracks (144, 146) are parallel to one another;
- on the tracks, at least one pair (160) of current collector regions (164, 166) extend, in the direction (X) of the tracks (144, 146), on either side of a separation (168) between the regions all the way to two opposite edges (165, 167) of the regions; and
- the separation is oblique with respect to the tracks and the two opposite edges are orthogonal to the tracks.

2. Component according to claim 1, wherein the current collector regions (14, 166) have the shape of right-angled triangles.

3. Component according to claim 1, wherein the current collector regions (14, 166) have the shape of right-angled trapezoids.

4. Component according to any of claims 1 to 3, wherein each of said tracks (144, 146) passes under at least one of the two regions (164, 166).

5. Component according to any of claims 1 to 4, wherein said tracks (144, 146) comprise first connection tracks (144) of first electrodes and second connection tracks (146) of second electrodes arranged in alternated fashion.

6. Component according to claim 5, wherein one of the regions (164) in the pair (160) is connected by vias (184) to the first tracks (144) and another one of the regions (166) in the pair is connected by vias (186) to the second tracks (146) .

7. Component according to any of claims 1 to 6, wherein said regions (164, 166) are portions of a same metal layer (162).

8. Component according to any of claims 1 to 7, wherein said pair (160) is regularly repeated in a direction (X) parallel to the tracks (144, 146).

9. Component according to claims 7 and 8, wherein:
- first regions (164) of the pairs (160) extend from a same first strip (210) of the metal layer (162), the first strip extending parallel to the tracks (144, 146); and
- preferably, first regions (166) of the pairs extend from a same second strip (220) of the metal layer, the second strip extending parallel to the tracks.

10. Component according to claim 8 or 9, wherein a space between neighboring pairs (160) has a width substantially equal to a width (W) of the separation (168).

11. Component according to any of claims 1 to 10, wherein said regions (164, 166) each have a connection area (190).

12. Component according to claim 11, wherein the areas (190) are entirely located above said tracks (144, 146) and spaces between said tracks.

13. Component according to claim 11 or 12 as dependent on claim 3, wherein the connection areas (190) of the regions (164) connected to the first tracks (144) are connected to a first terminal (194) of the component, and the connection areas of the regions (166) connected to the second tracks (146) are connected to a second terminal (196) of the component.

14. AlGaN/GaN component according to any of claims 1 to 13.

15. Transistor (100, 200) comprising one or a plurality of components according to any of claims 1 to 14.

16. Transistor according to claim 15, comprising drain (126), gate (122), and source (124) electrodes forming strips elongated parallel to the tracks, the drain electrodes being connected by vias (156) to drain tracks (146) among said tracks, and the source electrodes being connected by vias (154) to source tracks (144) among said tracks.

17. Transistor according to claim 16, wherein the gate electrodes (122) are located under the source tracks (144).
